# EUROPÄISCHE PATENTSCHRIFT

(11) **EP 0 899 993 B1**
(45) Veröffentlichungstag und Bekanntmachung des Hinweises auf die Patenterteilung: **20.09.2000**
(21) Anmeldenummer: 98111822.7
(22) Anmeldetag: 26.06.1998
(51) Int. Cl.: H05K 9/00

(54) **Gerätegehäuse**
Apparatus housing
Boîtier d'appareillage

(30) Priorität: 20.08.1997 DE 19736026
(43) Veröffentlichungstag der Anmeldung: 03.03.1999
(73) Patentinhaber: DMT GmbH Feinwerktechnische Komplettlösungen, 71034 Böblingen (DE)
(72) Erfinder: Kopp, Siegfried, 71272 Renningen (DE); Häberle, Jürgen, 71032 Böblingen (DE); Schwegler, Tim, 71069 Sindelfingen (DE)
(74) Vertreter: Rudolph, Wolfgang

(56) Entgegenhaltungen:
- US-A- 5 031 027
- US-A- 5 136 119
- US-A- 5 256 086
- US-A- 5 545 844
- US-A- 5 581 047

## Beschreibung

Die Erfindung betrifft ein Gerätegehäuse nach dem Oberbegriff des Patentanspruches 1.

Gerätegehäuse in den verschiedensten Formen und aus unterschiedlichem Material, insbesondere für elektrische und elektronische Geräte und Meßgeräte sind grundsätzlich bekannt. In den Gerätegehäusen sind Chassis zur Aufnahme der Gerätekomponenten angeordnet. Die Komponenten sind je nach Art des Gerätes entweder Leiterplatten, Speicherplatten, Ventilatoren, Lautsprecher, Kühlvorrichtungen, Pumpen, Getriebe u.s.w.. Das Chassis hat den Zweck, die einzelnen Komponenten innerhalb des Gerätes mechanisch in einer bestimmten Position zu fixieren. Ein derartiges Chassis umfaßt normalerweise einen Rahmen mit mehreren Unterteilungen, in denen die Komponenten befestigt werden. Der Rahmen selbst wird an einem äußeren Gehäuse des jeweiligen Gerätes befestigt.

Es ist auch seit langem bekannt, Teile aus hartem Kunststoff für ein Chassis zu verwenden, wobei die Montage wie beim Metallchassis kompliziert und zeitaufwendig ist, da Befestigungselemente, wie Schrauben, Nieten, Bänder und Haltevorrichtungen erforderlich sind. Außerdem müssen elektromagnetische Abschirmvorrichtungen vorgesehen werden, in dem Kunststoffteile mit dem leitfähigen Material abgedeckt werden und/oder in dem Metallplatten oder -folien an dem Chassis befestigt werden. Derartige Chassis sind mechanisch zu kompliziert aufgebaut und die Montage sowie das Anbringen von Komponenten ist zu teuer.

Um diese Nachteile zu beseitigen, wird in dem Deutschen Gebrauchsmuster 9116755.8 und dem entsprechenden EP-A-0 546 211 ein Chassis eines Gerätes, beispielsweise eines Computers oder elektronischen Meßgerätes beschrieben, das mehrere, das Gerät bildende Komponenten, zum Beispiel Leiterplatten, Speicherplatten, Ventilatoren u.s.w. hält. Eine Trägereinheit aus Kunststoff wie Hartschaumstoff weist Aussparungen auf, die jeweils an die äußeren Formgebungen der Komponenten angepaßt sind, wobei die Komponenten in der Trägereinheit in einer im wesentlichen formschlüssigen Weise gehalten sind und von der Trägereinheit umschlossen werden, wenn sie hierin eingesetzt sind, ohne daß Befestigungselemente benötigt werden. Die Trägereinheit besteht aus einem unteren Teil, in das die Komponenten eingesetzt werden können, wenn das Chassis zusammengebaut wird, und einem oberen Teil für die paßgenaue Abdeckung des unteren Teils mit den eingesetzten Komponenten. Das obere ist für einen Zugriff auf die in dem unteren Teil eingesetzten größeren Komponenten abnehm- oder hochschwenkbar. Die Trägereinheit weist Lüftungskanäle auf, die in dem Kunststoff ausgeformt sind, wobei ein Ventilator in einem Lüftungskanal so angeordnet ist, daß der von dem Ventilator erzeugte Luftstrom über Komponenten führt, die zu kühlen sind. Das Chassis kann auch so ausgestaltet sein, daß Aussparungen in unterschiedlichen Ebenen ausgebildet sind, so daß Komponenten übereinander angeordnet werden können. Das Chassis besteht aus einem Kunststoff, der eine Dichte von annähernd 60 bis 80 g/l hat. Als sehr vorteilhafter Kunststoff hat sich expandierendes Polypropylen bei der Realisierung herausgestellt. Polypropylen ist ein leichtes Material, kann leicht in unterschiedliche Formen formgepreßt werden, ist stoßabsorbierend, elastisch, weist ein inhärentes Rückstellverhalten auf, ist darüberhinaus deformierbar und nachgebend und weist dennoch eine hohe Formstabilität auf. Weiterhin ist Polypropylen temperaturstabil und chemisch resistent. Es kann vollständig wiederverwertet werden und ist somit vom Gesichtspunkt des Umweltschutzes her sehr vorteilhaft. Es sind jedoch auch Materialien wie Polyurethan und Polyäthylen und ähnliche Kunststoffe für das Chassis verwendbar. Das obengenannte Chassis benötigt jedoch immer ein Gehäuse aus Metall oder aus einem metallisierten Hartkunststoff. Dabei hat es sich als vorteilhaft herausgestellt, wenn das Chassis von einer Metalleinfassung umgeben ist, die an ihrer Vorderseite und an ihrer Rückseite offen ist, so daß das Chassis in die Einfassung durch eine dieser Öffnungen eingesetzt werden kann. Eine vordere und eine hintere Abschirmplatte, die typischerweise aus Metall gefertigt sind, bedecken die vorderen bzw. hinteren Flächen eines solchen Chassis.

Außerdem ist durch das Deutsche Gebrauchsmuster 29 704 237.8 bekannt, das aus einem Chassis oder Komponententräger der oben beschriebenen Art besteht, das in bereits vorhandene Kästen oder dergleichen von Labor-, Büro-, Werkstatt- und Heimmöbel oder dergleichen einsetzbar gestaltet ist, wobei das Chassis bzw. der Komponententräger mit dem bereits vorhandenen Kasten, wie zum Beispiel einem Kasten eines Schreibtisches, eine integrale und funktionale Einheit bildet.

Dieses Gerätegehäuse besteht aus einem Kunststoff-, insbesondere Hartschaumstoffchassis bzw. -träger, zur Aufnahme der Gerätekomponenten und einem Kasten bzw. einer Schublade aus Metall oder mit einer Metallschicht, einem Metallblech oder einer Metallfolie ausgekleidet, eines Möbels, wie zum Beispiel eines Schreibtisches oder eines Schrankes bzw. Schrankteils, wobei das Kunststoff- bzw. Schaumstoffchassis mit elastischen Ohren ausgestattet ist, die als Halte-/Klemmvorrichtungen dienen und deren Zwischenräume in Verbindung mit dem Metallkasten oder dergleichen einstellbare bzw. steuerbare Luftkanäle bilden, die durch einsteckbare, einschiebbare oder verschiebbare Kunststoffteile ein leicht anpassbares Lüftungssystem für die jeweiligen Komponenten ermöglichen. Dadurch können zum Beispiel Computer, Meßgeräte, Laborgeräte, Multimediageräte oder dergleichen im Kasten eines Schreibtisches oder eines Labortisches bzw. in einem Einschub bzw. einer Schublade eines sonstigen Möbelstückes untergebracht werden, wobei der jeweilige Kasten bzw. Einschub und das Kunststoffchassis eine integrale und funktionale Geräteeinheit und damit das eigentliche Gerätegehäuse mit Lüftungssystem bilden.

Die Montage und die Funktionstüchtigkeit des zum Beispiel Schubkastencomputers ist durch die spezielle Gestaltung des Kunststoffchassis in hervorragender Weise gegeben, ohne daß das sonst immer erforderliche zusätzliche Metallgehäuse oder metallisierte Kunststoffgehäuse für ein Gerät erforderlich ist.

Außerdem sind in den US-A-5,581,047 und US-A-5,031,027 faltbare elektrische Abschirmungen für elektronische oder elektrische Schaltkreise bekanntgeworden. Sie dienen zur Abschirmung von einzelnen elektronischen Komponenten innerhalb eines Gerätes oder eines Schaltungskomplexes. Das faltbare metallische Abschirmmaterial wird dabei allein verwendet oder in Form eines laminierten Materials. Die Dicke des Materials erlaubt es, eine Gestaltung entsprechend der äußeren Formgebung des Bauelementes bzw. des Schaltkreises zu erreichen, indem es zum Beispiel sehr flach und anschmiegend gestaltet werden kann. Es ist jedoch nicht für Gehäuse für ganze Geräte bzw. Apparate geeignet.

Es hat sich nun herausgestellt, daß diese speziellen Lösungen durchaus die angegebenen Vorteile haben, jedoch für Geräte und Apparate nicht geeignet sind und darüberhinaus für solche, die für eine sichtbare Aufstellung konzipiert sind, nicht anwendbar, zu teuer oder zu unflexibel sind und nur kompliziert an die Umgebung im äußeren Design angepaßt werden können.

Der Erfindung liegt die Aufgabe zugrunde, ein einfach herstellbares Gehäuse für elektronische Geräte mit einem Chassis bzw. Komponententräger der zuvor beschriebenen Art zu schaffen, das von Nichtfachleuten leicht auszuwechseln, im äußeren Design, das heißt in der äußeren Gestaltung problemlos zu verändern, oder an die Umgebung anzupassen ist, für den Transport und die Lagerung platzsparend und leicht gestaltet ist und trotzdem die elektrischen Abschirmungsnormen bzw. -spezifikationen, wie DIN EN 55022, enthält IEC CISPR 22, voll erfüllt.

Die erfindungsgemäße Lösung ist in den Kennzeichen der Ansprüche 1 und 3 charakterisiert.

Weitere Ausgestaltungen bzw. Lösungen der Aufgabe sind in den Ansprüchen 3 bis 19 charakterisiert.

Die vorliegende Erfindung bringt neben anderen die folgenden zusätzlichen Vorteile:

Die Anzahl der Teile, die das eigentliche Gerätegehäuse bilden, ist auf eins verringert worden, die Anforderungen hinsichtlich der Fertigungstoleranzen sind geringer als bei einem Gehäuse und Chassis aus einem Metall- oder hartem Kunststoffkörper nach dem Stand der Technik, bei dem zusammenzubauende Teile mit großer Präzision hergestellt werden müssen, um ein genaues Zusammenpassen der verschiedenen Teile sicherzustellen. Die Komponenten können jetzt beim Herstellungsprozeß in das Chassis leicht eingesetzt werden. Sie werden ohne zusätzliche Haltematerialen darin geklemmt festgehalten. Das Chassis ist wiederum in eine gefaltete Hülle bzw. ein gefaltetes Gehäuse aus einem Stück bzw. einer Platine oder einem faltbaren Zuschnitt von Laminat, Pappe, Wellpappe oder ähnlichem Material mit entsprechenden Durchbrüchen, sehr leicht einsetzbar. Es geschieht lediglich durch Falten, Inneneinanderklappen und -stecken von Seitenwänden, Boden und Deckel.
- Das Gewicht ist wesentlich gegenüber den bisher bekanntgewordenen Konstruktionen verringert worden;
- es wird durch eine aufgebrachte Metallschicht/-folie oder ein Metallgeflecht/-gewebe eine sehr gute Partikelabschirmung, elektrische Abschirmung und geringe Abstrahlung bewirkt, die den zur Zeit höchsten Anforderungen nach Spezifikation Cispr. 22.2 Class B, 30 MZ - 1 GHz genügt und darüberhinaus elektrostatische Ent- bzw. Aufladung wirkungsvoll verhindert. Durch innere Luftführungskanäle und entsprechende Durchbrüche im Gehäuse bzw. der -hülle wird eine sehr wirksame Kühlung der Komponenten verwirklicht;
- die Schirmung und Kontaktierung der Flächen des Gehäuses wird durch hohe Oberflächenleitfähigkeit der innenliegenden Metallschicht und die besondere geometrische Gestaltung deren Überlappungsstellen an den Schnitt- und/oder Faltstellen durch ein gestaltetes Labyrinth erreicht, das einem Faradayschen Käfig bildet. Messungen haben excellente Werte ergeben.
- die Komponenten sind durch die Eigenschaften des Gehäuse- und Chassismaterials stoßabsorbierend angeordnet. Aufgrund der stoßabsorbierenden Funktion des Chassis und des Gehäuses sind die Anforderungen hinsichtlich der damit geschaffenen stoßgeschützten Verpackung des Gerätes während eines Transports verringert. Verpackungsmaterial und Transportvolumen werden dadurch auch wesentlich verringert;
- das Auswechseln des Gehäuses und dessen äußere Gestaltung ist so problemlos vielfältig und einfach wie die Montage. Die Gestaltungsvielfalt, die Wartung und gewünschte leichte und kostengünstige Änderung des äußeren Designs der Geräte ist einfach realisierbar geworden.

Es soll hier betont sein, daß der Erfindungsgegenstand nicht auf elektronische oder feinmechanische Geräte wie Computer oder Meßinstrumente beschränkt ist, sondern für alle Arten von Geräten verwendet werden kann.

Weitere Merkmale der Erfindung ergeben sich aus der nachfolgenden Beschreibung und der Zeichnung.

Die Erfindung wird nun anhand von in der Zeichnung dargestellten Ausführungsbeispielen näher erklärt. In der Beschreibung, in den Schutzansprüchen und in den Figuren werden für gleiche Teile die in der hinten angegebenen Liste der Bezugszeichen aufgeführten Bezugszeichen und Begriffe verwendet.

In der Zeichnung bedeuten:
- Fig. 1: einen flachen Zuschnitt einer Falt-Box, eines Gerätegehäuses bzw. einer -hülle;
- Fig. 1A: Einzelheiten eines Umschlages für die Kontaktierung;
- Fig. 2: eine detailliertere Darstellung einer Box bzw. eines aufgeklappten, gefalteten Gerätegehäuses mit teilweise auseinandergezogener Darstellung des speziellen Kunststoffchassis sowie bestimmter Teile bzw. Komponenten;
- Fig. 3: Darstellung eines Gerätes mit heruntergeklappten Seitenwänden;
- Fig. 4: fertig montiertes Gerät vor dem Zuklappen der Falt-Box;
- Fig. 5: Darstellung einer Variante der Falt- und Umschlagtechnik zum Erreichen eines elektrostatischen Labyrinths sowie der Statik bzw. Festigkeit des Gerätegehäuses;
- Fig. 5A: Umschlagtechnik im Detail;
- Fig. 6: elektisches Labyrinth und Kontaktierung;
- Fig. 7: Darstellung der Gehäuse-/Leiterplattenkontaktierung und Masseverbindung und
- Fig. 8A-H: Darstellung einer Faltfolge und Umschlagtechnik des Einschnittes zum Erstellen eines Gerätegehäuses.

Vor der detaillierten Beschreibung der Figuren soll zunächst noch folgendes ausgeführt werden:

Das hier beschriebene Gehäuse für ein elektrisches bzw. elektronisches Gerät besteht aus einer Falt-Box aus Pappe, Laminatmaterial bzw. aus einem Verbundstoff oder einem Material mit ähnlichen Eigenschaften. Zum Erreichen der Abschirmung nach dem Faraday-Käfig-Prinzip ist die Pappe, das Verbundmaterial bzw. das Laminat mit einem Material versehen, das eine niedrigohmige Oberflächenleitfähigkeit aufweist. Ein derartiges Material kann zum Beispiel eine Metallfolie, ein Metallgewebe oder ein Metallnetz sein, es kann jedoch auch eine dünne Metallschicht, die direkt aufgebracht ist, sein. Die Box selbst, bzw. der Träger für das Material mit niedrigohmiger Oberflächenleitfähigkeit kann zum Beispiel Pappe, Wellpappe, eine dickere Folie, Stoff, Leder oder eben auch Termoplaste bzw. Duroplaste, wie zum Beispiel Harz-Glasfaserwerkstoff sein. Die geometrische Grundform des Gehäuses wird im wesentlichen durch das innenliegende Chassis bzw. den Komponententräger bzw. durch bestimmte Anforderungen an das Gerät bestimmt. Zunächst wird ein Zuschnitt einer Falt-Box bzw. eines Gerätegehäuses aus dem Laminatmaterial bzw. Verbundmaterial hergestellt. Die kubische Formgebung wird durch Aufstellen, Ineinanderstecken bzw. Klappen und Falttechnik erreicht. Die Falttechnik ermöglicht gleichzeitig eine einwandfreie Kontaktfläche und eine einwandfreie Abschirmung. Dabei ist die geometrische Gestaltung der Überlappung an den Schnittflächen entlang einer Kante wichtig.

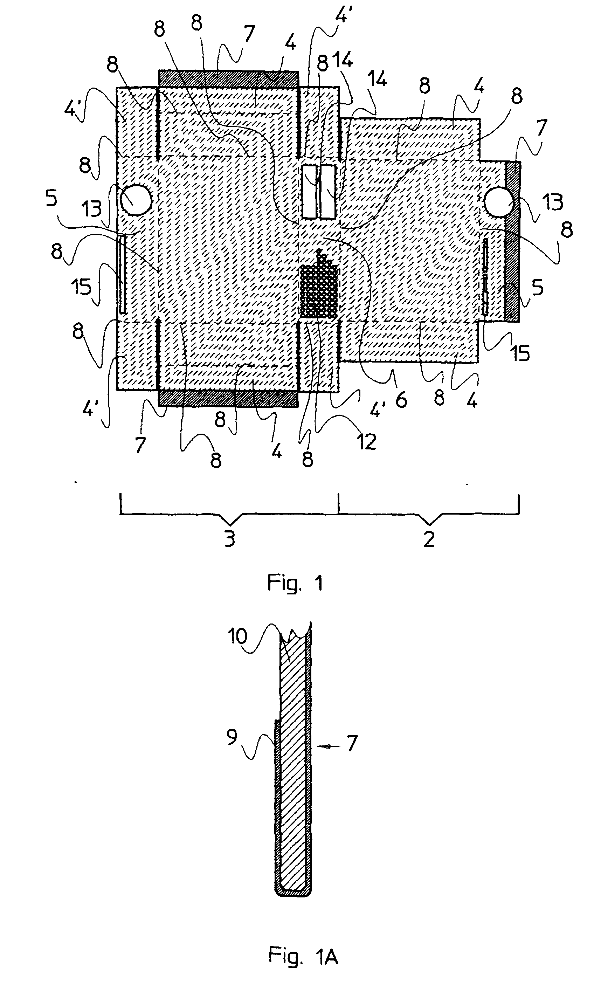

Die mechanische Funktion des Gehäuses bzw. des gesamten Gerätes wird erreicht durch die Verwendung von Chassis bzw. Komponententrägern aus Schaumstoff, wie bereits in der Einleitung detailliert beschrieben, in Verbindung mit der in Fig. 1 bis 8A-H beschriebenen Falt-Box oder -hülle. Dadurch ist die Bildung einer Gerätestabilität und der geforderten Gerätestatik sowie dem Kühlungskonzept durch Luftkanäle voll Rechnung getragen.

Bei der Verwendung eines elektrisch leitenden, luftdurchlässigen Materials wie zum Beispiel einem Netz, einem Metallgewebe oder Stoff mit Metallfäden bzw. -partikelchen können großflächige Öffnungen zur Gerätebelüftung bzw. -kühlung abgedeckt werden und somit ein Berührungsschutz und ein kompletter Faraday-Käfig (die Abschirmung bleibt funktionsfähig) erreicht werden. Die mechanische Funktion des Gehäuses bzw. des Gerätes wird erreicht durch die Verwendung eines Gerätechassis bzw. Komponententräger aus Hartschaumstoff in Verbindung mit der beschriebenen Falt-Box. Dadurch wird die Gerätefestigkeit bzw. die geforderte Gerätestatik mit einem einwandfreien Kühlungskonzept durch die im Chassis vorhandenen Luftkanäle und in der Box vorgesehenen Öffnungen bzw. Durchbrüche ermöglicht.

Das Zusammensetzen des kompletten Gerätes bzw. des Komponententrägers bzw. Chassis mit der Falt-Box erfolgt durch Falten und Zusammenstecken. Da die Falt-Box aus Pappe, Laminat oder dergleichen besteht, ist es auch leicht möglich, diese bei Bedarf gegen eine neue oder andere auszuwechseln. Durch die äußere Oberflächengestaltung ist ein solch ausgestattetes Gerät praktisch auf jede Umgebung ohne weiteres und preisgünstig anpaßbar. Außerdem ist die Lagerung der einzelnen Teile sehr einfach, da die Box im ungefalteten Zuschnitt flach gelagert werden kann und das Kunststoffchassis entweder mit Komponenten oder auch ohne Komponenten ebenfalls sehr leicht gelagert und transportiert werden kann. Das Zusammenfügen des Chassis, der Komponenten und der eigentlichen Box zu einem kompletten Gerät kann somit nicht nur während eines Fertigungsvorgangs ausgeführt werden, sondern auch erst beim Händler bzw. beim Endbenutzer. Es sind keinerlei besondere Werkzeuge oder Fertigkeiten erforderlich. Der Verschluß zwischen Oberteil und Unterteil bzw. Deckel und Boden kann an den offenen Kanten mittels Klettverschluß oder Reißverschluß, zur besseren Abschirmung auch metallisiert ausgeführt, oder mit Druckknöpfen oder dergleichen erfolgen.

In Fig. 1 ist ein Zuschnitt für eine Falt-Box bzw. ein Gerätegehäuse dargestellt, der in der Massenfertigung durch Ausstanzen aus Materialbahnen entsteht.

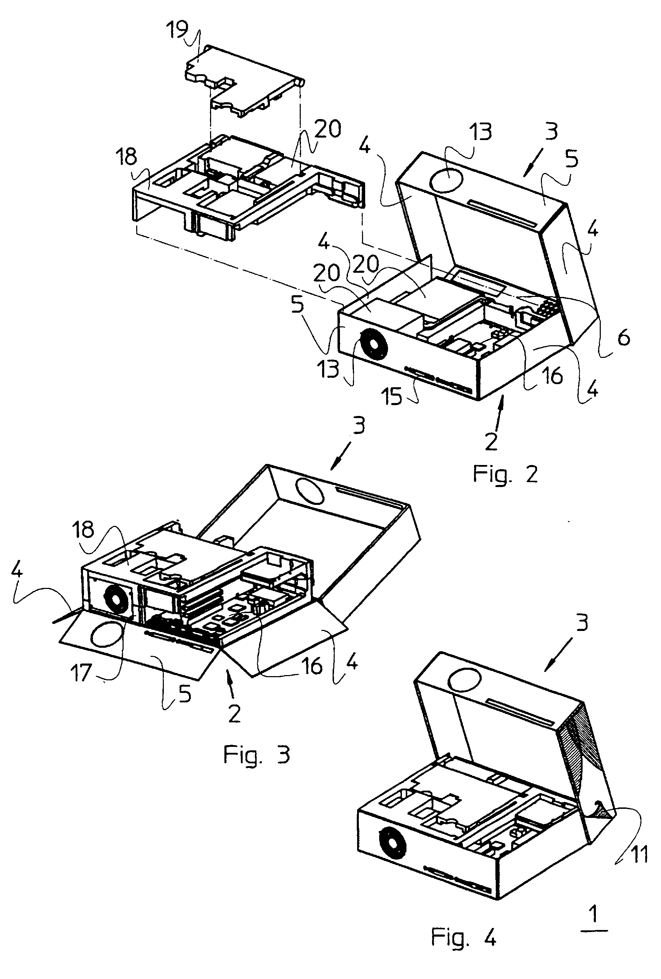

Der flache Zuschnitt des Gerätegehäuses bzw. der Falt-Box 1 weist einen Boden bzw. ein Unterteil 2, einen Deckel bzw. ein Oberteil 3, Seitenwände 4, 4' für die Unter- bzw. Oberteile, Rückwände 5 für die Unter- und Oberteile und eine Vorderwand 6 sowie einen Umschlag 7 auf. Der Umschlag 7 ist immer beidseitig metallisiert wie es in Fig. 1A dargestellt ist, um einen einwandfreien Kontakt der niederohmigen Metalloberfläche im gefalteten Zustand und damit die einwandfreie Funktion des Faradayschen-Käfigs zu gewährleisten. Die Falt-Box 1 besteht zum Beispiel aus einem Laminat oder Verbundwerkstoff, der auf einer Seite mit einer Schicht 9 aus Metallfolie, -netz oder -gewebe versehen ist. Auch Pappe, Wellpappe, Leder, Kunststoff oder dergleichen stellen geeignetes Material für den eigentlichen Träger 10 der niederohmigen Schicht 9 dar. Auf der nach außen gekehrten Oberfläche des Trägers 10 bzw. der Falt- oder Gerätebox 1 kann das gewünschte Design entweder aufgedruckt werden oder durch eine aufgeklebte Designfolie 11 nach Fig. 4 erzielt werden. Außerdem weist der Zuschnitt nach Fig. 1 Durchbrüche 12 für den Lufteintritt, Durchbrüche 13 für den Luftaustritt, Durchbrüche 14 für die Laufwerke und Durchbrüche 15 für die Steckerleisten auf.

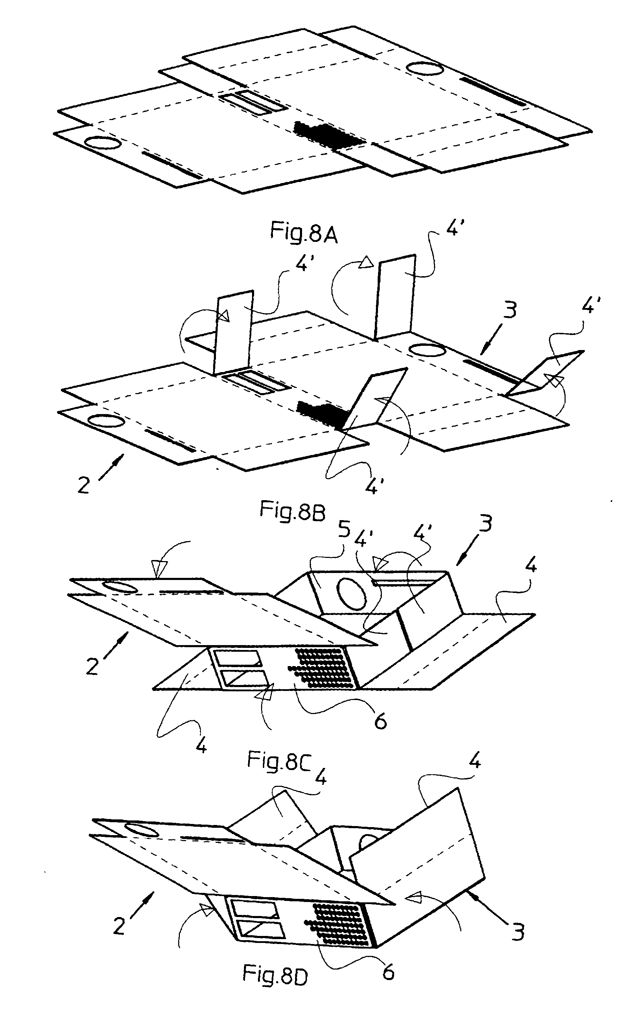

Die gestrichelt eingezeichneten Faltlinien bzw. -kanten 8 markieren die zu faltenden Stellen entsprechend der Faltfolge nach Fig. 8A-H, anhand der das Zusammenfügen zu einem Gerätegehäuse und die erforderliche Faltfolge detailliert beschrieben wird.

In Fig. 2 ist eine detaillierte Darstellung eines aufgeklappten bzw. gefalteten Gerätegehäuses mit teilweise auseinandergezogener Darstellung des Kunststoffchassis sowie bestimmter Komponenten dargestellt. Das Gerätegehäuse selbst besteht aus einem Unterteil bzw. Boden 2 und aus einem Oberteil bzw. Deckel 3, die sich hier schon im gefalteten Zustand des Zuschnitts nach Fig. 1 befinden. Dieser Darstellung sind auch deutlich die Seitenwände 4, die Hinterwände 5, die Vorderwand 6, die Durchbrüche 13 für den Luftaustritt, die Durchbrüche 15 für die Steckerleiste und die Leiterplatte 16 mit Komponenten zu sehen. Außerdem sind auch die Großkomponenten 20, wie zum Beispiel Laufwerke, Netzteile und Lüfter deutlich zu sehen, die im Chassisunterteil 17, das in dieser Darstellung nicht zu sehen ist, gehalten werden. Darauf wird zur Fixierung der Komponenten das Chassisoberteil 18 mit dem klappbaren bzw. schwenkbaren Halteteil 19 für die Großkomponenten 20 aufgesetzt und danach der Deckel bzw. das Oberteil 3 heruntergeklappt und somit das Gerätegehäuse geschlossen.

Beim Schließen des Gerätegehäuses erfolgt auch die Kontaktierung der einzelnen metallisierten Oberflächen untereinander, wie zum Beispiel durch die in Fig. 1 und 1A dargestellten Umschläge 7 in einem Faraday-Käfig. Wie bereits vorher beschrieben, kann das Gerät an den offenen Kanten mit entsprechenden Reißverschlüssen, Klettverschlüssen oder Druckknöpfen oder auch durch entsprechend angebrachte Schrauben völlig, zum Beispiel staubdicht, geschlossen werden.

In Fig. 3 ist das Gerätegehäuse als Falt-Box mit dem fertig gefalteten Deckel 3 und heruntergeklappter(n) Vorderwand 6 und Seitenwänden 4 des Unterteils bzw. Bodens 2 und einem aufgesetzten Komponententräger bzw. einem aufgesetzten Chassis, bestehend aus dem Chassisunterteil 17 und dem - oberteil 18 sowie der Leiterplatte 16 mit eingesetzten Komponenten, dargestellt. Dies zeigt, daß das Einsetzen des Chassis bzw. der Komponenten in ein derartiges Faltgehäuse äußerst einfach zu bewerkstelligen ist, da nach dem Daraufsetzen lediglich noch die Seitenwände 4 hochgeklappt werden müssen und der Deckel 3 geschlossen werden muß.

In Fig. 4 ist das so fertig montierte Gerät mit der Falt-Box 1 vor dem Zuklappen des Deckels bzw. Oberteils 3 dargestellt. Auch in diesem Zustand ist das Innere des Gerätes noch leicht zu erreichen und zum Beispiel für Servicezwecke und für Prüfzwecke am Ende des Fertigungsprozesses oder beim Kundendienst leicht und einfach zu handhaben. Das mögliche Auseinanderfalten erhöht die Zugänglichkeit beträchtlich.

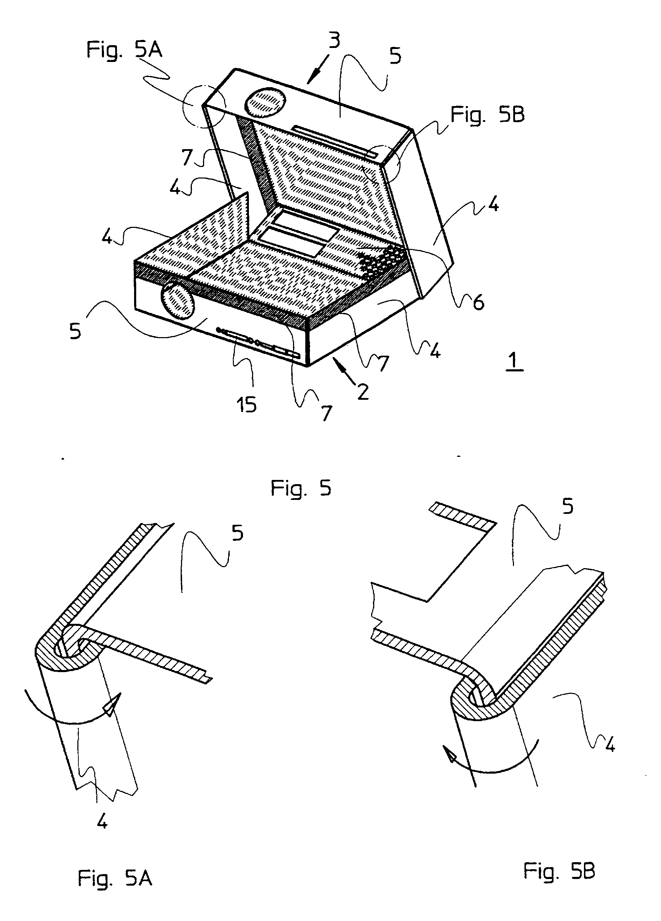

In Fig. 5 ist die Falt-Box 1 im zusammengefalteten, jedoch offenen Zustand dargestellt. In dieser Darstellung sind noch einmal ganz klar die Umschläge 7 zur Kontaktierung zu sehen, die beim Schließen des Deckels 3 die sichere Kontaktierung der niederohmigen Metalloberfläche zur Abschirmung nach innen und außen im Inneren des Gerätes sicher bewirken. Der Kontakt der Umschläge 7 an den Seitenwänden 4 und der Rückwand 5 des Unterteils 2 mit den Umschlägen 7 der Seitenwände 4 und der Rückwand 5 des Oberteils 3 ist insbesondere dadurch äußerst funktionssicher, daß zum Beispiel die nach innen gefalteten Seitenwände 4 sowohl des Unterteils 2 als auch des Oberteils 3 durch die durch die Faltung hervorgerufenen Kräfte immer wieder zurück in ihre flache Ausgangsstellung wollen und sich somit gegenseitig fest aneinander drücken und somit einwandfreien Kontakt geben.

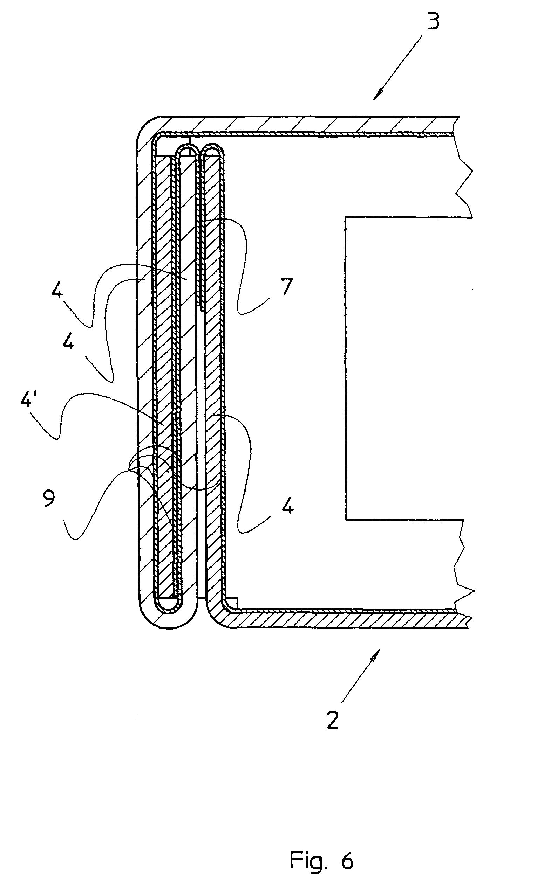

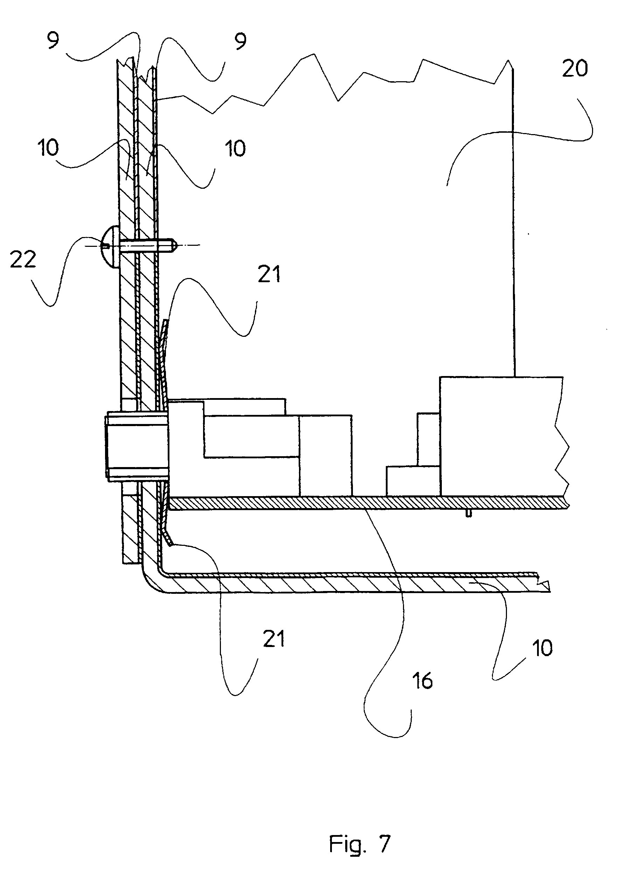

In den Figuren 5A und 5B sind Details der Falt- und Umschlagtechnik an der linken Vorderkante des Deckels 3 gezeigt. Durch das Ineinanderstecken und Falten der Seitenwände 4 und der Rückwand 5 wird einmal das elektrische Labyrinth zur Abschirmung und zum anderen die Statik des gesamten Gehäuses bzw. der Falt-Box 1 erreicht. Diese Umschlagtechnik ist nocheinmal detailiert in den Faltschritten 1 bis 4 gemäß den Figuren 8B-E gezeigt. Aus diesem Grunde wird hier nicht näher auf diese einzelnen Faltschritte eingegangen. In Fig. 6 ist die bereits beschriebene eindeutige Kontaktierung zwischen der metallisierten Schicht 9 bzw. Oberfläche des Deckels 3 und des Bodens 2 gezeigt. Es ist hier ganz klar zu sehen, daß die Umschläge 7 sowohl von den Seitenwänden 4, 4' des Deckels 3 als auch von den Seitenwänden 4 des Bodens 2 in einer einwandfreien elektrischen Verbindung miteinander sind. Dies wird dadurch noch unterstützt, daß wie bereits beschrieben, die metallisierten Umschläge 7 dadurch gegeneinander gedrückt werden, daß die Seitenwände 4 das Bestreben haben, wieder in die Ausgangslage vor dem Faltprozeß zu gelangen. In Fig. 7 ist ein Detail zur Kontaktierung der Leiterplatte 16 und anderer Komponenten 20 bzw. Steckerbuchsen und Steckerleisten mit der metallisierten Oberfläche 9 des Trägers oder Substrates 10 der Falt-Box 1 dargestellt. Die Kontaktierung-Masseanbindung ist zum Beispiel durch das Anschrauben einer Masseschraube 22 und/oder durch Federkraft, wie durch den Massekontakt 21 dargestellt, möglich.

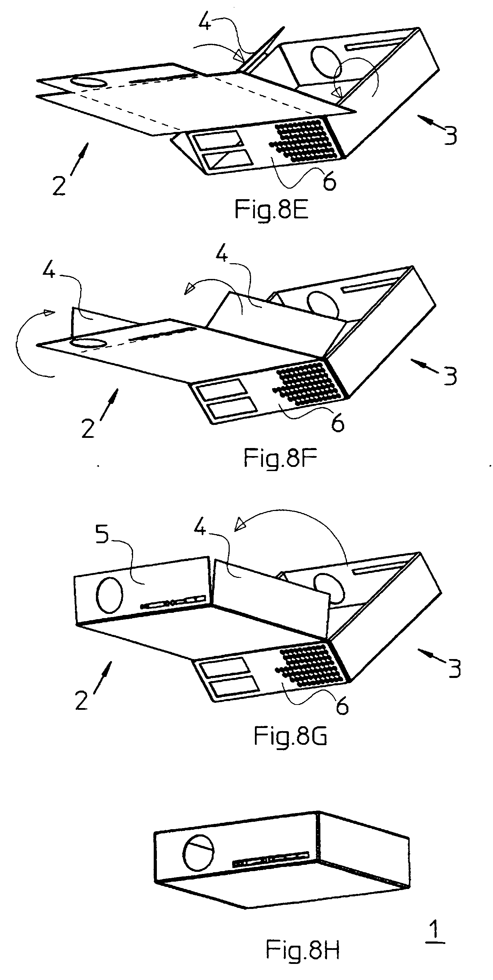

In den Figuren 8A-H ist die Faltfolge zur Erstellung einer Falt-Box 1 dargestellt. In Fig. 8A ist zunächst der flache Zuschnitt gemäß Fig. 1 dargestellt. Der erste Faltschritt nach Fig. 8B besteht darin, daß die inneren geteilten Seitenwände 4' des Deckels 3 hochgeklappt werden. Im zweiten Faltschritt werden gemäß Fig. 8C die Rückwand 5 und die Vorderwand 6 hochgeklappt, wodurch zusammen mit den geteilten inneren Seitenwände 4' bereits ein karton- oder kastenartiges Gebilde entsteht. An der Unterseite (liegt in dieser Darstellung oben) der Vorderwand 6 ist untrennbar der noch nicht gefaltete Boden 2 angeordnet, der nach hinten abgeklappt ist. Im Faltschritt 3 werden gemäß Fig. 8D nun auch die äußeren Seitenwände 4 des Deckels 3 hochgeklappt und dann gemäß Fig. 8E im vierten Faltschritt nach innen unten gefaltet. Damit ist der Deckel bzw. das Oberteil 3 bereits in seinem Endzustand. In Fig. 8F ist der fünfte Faltschritt dargestellt, der darin besteht, daß die Seitenwände 4 des Bodens 2 um 90° nach oben geklappt werden. Danach wird gemäß Fig. 8G die Rückwand 5 des Bodens 2 um 90° hochgeklappt. Das Hochklappen der Seitenwände 4 bzw. der Vorderwand 5 und der Rückwand 6 erfolgt entweder vor dem Einsetzen des Chassis oder auch nach dem Einsetzen des Chassis je nach den Erfordernissen des jeweiligen Fertigungsprozesses bzw. der Reparaturerfordernisse. In Fig. 8H ist das geschlossene Gerätegehäuse als komplette Falt-Box 1 in Vorderansicht dargestellt.

### Liste der Bezugszeichen

- 1: Falt-Box
- 2: Boden oder Unterteil
- 3: Deckel oder Oberteil
- 4: Seitenwände für Unter- bzw. Oberteil
- 4': innere Seitenwände des Deckels
- 5: Rückwände
- 6: Vorderwand
- 7: Umschlag
- 8: Faltlinien bzw. -kanten
- 9: leitfähige, niederohmige Schicht
- 10: Träger oder Substrat
- 11: Designfolie
- 12: Durchbrüche für Lufteintritt
- 13: Durchbrüche für Luftaustritt
- 14: Durchbrüche für Laufwerke
- 15: Durchbrüche für Steckerleiste
- 16: Leiterplatte mit Komponenten
- 17: Chassisunterteil
- 18: Chassisoberteil
- 19: Halteteil (für Großkomponenten)
- 20: Großkomponenten (Laufwerke, Netzteile, Lüfter u.s.w.)
- 21: Massekontakt
- 22: Masseschraube

## Patentansprüche

1. Gerätegehäuse für ein Kunststoffchassis bzw. für einen Komponententräger, insbesondere aus expandierendem Polypropylen, elektrischer, elektronischer, feinmechanischer oder mechanischer Komponenten, für elektrische, elektronische oder feinmechanische Geräte, wobei das Gerätegehäuse als Falt-Box (1) aus einem Träger oder Substrat (10) aus Verbundwerkstoff bzw. einem Laminat, Wellpappe oder Pappe besteht, und der Träger (10) auf der innenliegenden Gehäuseseite eine durchgehende elektrisch leitende und niederohmige Oberfläche bzw. leitfähige, niederohmige Schicht (9) aufweist, dadurch gekennzeichnet,
daß der flache Zuschnitt der Falt-Box (1) alle erforderlichen Durchbrüche (12-15), im Gebrauch kompatibel zu einem bestückten Chassis bzw. bestückten Komponententräger (17, 18) aufweist, und zu einer Falt-Box (1) mit innenliegendem Faraday-Käfig faltbar ausgebildet ist.

2. Gerätegehäuse nach Patentanspruch 1, dadurch gekennzeichnet,
daß die Falt-Box (1) aus einem Unterteil oder Boden (2) und einem Deckel oder Oberteil (3) besteht, die miteinander an einer Kante klappbar materialschlüssig miteinander verbunden sind und
daß die leitfähige Schicht (9) an den Seitenwänden (4) und an den Vorderwänden (6) des Bodens (2) einen streifenförmigen Umschlag (7) aufweist der zur Kontaktierung der leitfähigen Oberfläche des Deckels (3) und des Bodens (2) im zusammengefalteten Zustand dient.

3. Gerät mit einem Gehäuse als Falt-Box (1) gemäß Patentanspruch 1 oder 2, und einem Kunststoffchassis bzw. einem Komponententräger, insbesondere aus expandierendem Polypropylen, für elektrische, elektronische, feinmechanische oder mechanische Komponenten, für elektrische, elektronische oder feinmechanische Geräte, wie zum Beispiel Personalcomputer oder Laborgeräte, dadurch gekennzeichnet,
daß die Faltbox (1) und das Chassis bzw. der Komponententräger (17, 18) eine integrale elektrische Einheit gegen Ab- und Einstrahlung sowie eine statische mechanische Einheit bilden.

4. Gerätegehäuse oder Gerät nach einem der Patentansprüche 1 bis 3, dadurch gekennzeichnet,
daß die Außenflächen der Falt-Box (1) teilweise oder ganz mit Designfolie (11) verbunden sind.

5. Gerätegehäuse oder Gerät nach einem der Patentansprüche 1 bis 4, dadurch gekennzeichnet,
daß die Falt-Box (1) aus Kunststoff, Folie, Stoff, Pappe, Kunstleder oder Leder, die auf der einen Seite des Zuschnitts zur Schirmung bzw. Kontaktierung der innenliegenden Flächen mit Material hoher Oberflächenleitfähigkeit versehen ist, im zusammengefalteten Zustand einen innenliegenden Faraday-Käfig bildet.

6. Gerätegehäuse oder Gerät nach einem der Patentansprüche 1 bis 5, dadurch gekennzeichnet,
daß der Faraday-Käfig durch auf die Innenseiten und -oberfläche der Falt-Box (1) aufgebrachte Metallgewebe, Metallnetze, Metallfäden, Metallfolien, Metallschichten oder metallhaltige Schichten durch Falttechnik und streifenförmige Umschläge (7) zur Kontaktierung der metallischen Innenseiten, Flächen und Oberflächen realisiert ist.

7. Gerät nach einem der Patentansprüche 3 bis 6, dadurch gekennzeichnet,
daß die beiden Seitenwände (4) der Falt-Box (1) jeweils dreifach, die Rückwand (5) zweifach und die Vorderwand (6) einfach im gefalteten Endzustand angeordnet sind.

8. Gerät nach den Patentansprüchen 3 bis 6, dadurch gekennzeichnet,
daß die inneren Seitenwände (4') des Deckels (3) aus zwei faltbaren Teilen bestehen.

9. Gerät nach einem der Patentansprüche 3 bis 8, dadurch gekennzeichnet,
daß die Durchbrüche (12 - 15) für Lufteintritt, Luftaustritt, Laufwerke, Steckerleisten oder dergleichen durch Metallfasern bzw. Metallpartikelchen enthaltende Stoffe elektrisch leitend abgedeckt sind.

10. Gerät nach einem der Patentansprüche 3 bis 9, dadurch gekennzeichnet,
daß die Seitenwände (4) und die Rückwände (5) an ihren Stoßkanten offen und auf- und abklappbar ausgeführt sind.

11. Gerät nach einem der Patentansprüche 3 bis 10, dadurch gekennzeichnet,
daß eine Wand des Deckels (3) die Rückwand (5) und die andere Wand die Vorderwand (6) des Gerätes oder der Falt-Box (1) bilden und
daß der Deckel (3) auf- und abklappbar oder schwenkbar am Boden (2) angelenkt ist.

12. Gerät nach einem der Patentansprüche 3 bis 11, dadurch gekennzeichnet,
daß die Rückwand (5) des Gehäuses über eine vorhandene Steckerleiste oder geerdete Großkomponenten (20) mit dem Chassis (17, 18) oder einer geerdeten Leiterplatte (16) für die Komponenten durch mindestens einen als Schnapp- oder Einrastkontakt ausgebildeten Massekontakt (21) oder eine Masseschraube (22) verriegelt und kontaktiert ist.

13. Gerät nach einem der Patentansprüche 3 bis 12, dadurch gekennzeichnet,
daß die niederohmige leitfähige Oberfläche oder Schicht (9) des Trägers (10) mindestens an den oberen freien Kanten der Seitenwände (4) und der Rückwände (5) als streifenförmiger Umschlag (7) über die Kanten hinweg auf die gegenüberliegende Oberfläche ragt.

14. Gerät nach einem der Patentansprüche 3 bis 13, dadurch gekennzeichnet,
daß mindestens Umschläge (7) der Seitenwände (4) des Deckels (3) und des Bodens (2) sich spreizend unmittelbar aneinanderliegend, -drückend und kontaktierend ausgeführt sind.

15. Gerät nach einem der Patentansprüche 3 bis 14, dadurch gekennzeichnet,
daß mindestens die Seitenwände (4) und die Rückwand (5) des Bodens (2) abschwenk- bzw. -klappbar ausgestaltet sind.

16. Gerät nach einem der Patentansprüche 3 oder 15, dadurch gekennzeichnet,
daß offene Gerätekanten von Deckel (3) und Boden (2) miteinander durch Klettverschlüsse, Reißverschlüsse oder Druckknöpfe, gegebenenfalls metallisiert, verschlossen sind.

## Claims

1. Equipment housing for a plastic chassis or for a component carrier, specifically made of expanded polypropylene, electrical, electronic, precision or mechanical components for electrical, electronic or precision equipment, wherein the equipment housing is a folding box, consisting of a base or substrate (10) made from composite materials or a laminate, corrugated cardboard or cardboard, and the base (10) on the internal housing side, has a continuous electrically conductive and low impedance surface or conductive, low impedance layer (9), characterised in that
the flat folding box blank (1) has all the necessary perforations (12-15), compatible in use with an equipped chassis or component carrier (17, 18) and is designed for folding into a folding box (1) with an internal Faraday shield.

2. Housing for a device according to claim 1, characterised in that
the folded box (1) consists of a bottom section or base (2) and a lid or top section (3) that are hinged inseparably to each other along one edge, and
the conductive layer (9) has a stripe-shaped cover (7) on the side panels (4) and on the front panels (6) of the base (2) to provide contact with the conductive surface of the lid (3) and the base (2) when in the folded state.

3. Device with a housing in the form of a folding box (1) according to patent claims 1 or 2, and a plastic chassis or component carrier, specifically made of expanded polypropylene for electrical, electronic, precision or mechanical components for electrical, electronic or precision equipment such as personal computers or laboratory equipment, characterised in that
the folding box (1) and the chassis or component container (17, 18), represent an integral electrical unit providing shielding against irradiation and radiation emission, as well as a static mechanical unit.

4. Equipment housing or device according to one of the patent claims 1 to 3, characterised in that
the external surfaces of the folding box (1) are partially or fully bonded with design film (11).

5. Equipment housing or device according to one of the patent claims 1 to 4, characterised in that
the folding box (1) made of plastic, film, material, cardboard, artificial leather or leather, which has a material of high surface conductivity on one side of the blank to provide shielding or a contact for the internal surfaces, represents an internal Faraday shield when in the folded state.

6. Housing for a device according to one of claims 1 to 5, characterised in that
the Faraday cage is produced by the application of metal fabrics, metal nets, metal threads, metal foils, metal layers or layers with metal content to the inside surfaces of the folded box (1) as well as by the use of folding configurations and strip-shaped projections (7) to establish contacts between the metallic inside surfaces.

7. Housing for a device according to one of claims 3 to 6, characterised in that
the two side panels (4) of the folded box (1) are provided in triple form, the back panel (5) is provided in double form and the front panel (6) is provided in single form when the box is in its final erected state.

8. Housing for a device according to claim 3 to 6, characterised in that
the internal side panels (4') of the lid (3) consist of two foldable sections.

9. Housing for a device according to one of claims 3 to 8, characterised in that
the openings (12 - 15) to allow air in, to allow air out, for drives, plug connector strips etc. are covered in an electrically conductive form by materials containing metal fibres and/or metal particles.

10. Housing for a device according to one of claims 3 to 9, characterised in that
the side panels (4) and the back panels (5) are designed to be open where their edges meet and can be swivelled open and closed.

11. Housing for a device according to one of claims 3 to 10, characterised in that
one panel of the lid (3) forms the back panel (5) of the device / folded box (1) and the other panel forms the front panel (6) of the device / folded box (1) and
wherein the lid (3) is hinged to the base (2) and can be swivelled open and closed.

12. Device according to one of the patent claims 3 to 11, characterised in that
the back panel (5) of the housing is locked to or in contact with the chassis (17, 18) or an earthed printed circuit board (16) for the components through an existing connector strip or large earthed component through at least one earth contact (21) in the form of a snap-in or snap-on contact (22) or earthing screw.

13. Housing for a device according to one of claims 3 to 12, characterised in that
the low-impedance, conductive surface or layer (9) of the substrate (10) projects above the edges onto the surface opposite as a strip-shaped projection (7) at least at the free upper edges of the side panels (4) and the back panels (5).

14. Housing for a device according to one of claims 3 to 13, characterised in that
at least projections (7) of the side panels (4) of the lid (3) and the base (2) are designed to rest directly against, press against and establish contact with each other.

15. Housing for a device according to one of claims 3 to 14, characterised in that
at least the side panels (4) and the back panel (5) of the base (2) are designed so that they can be folded down.

16. Housing for a device according to one of claims 3 or 15, characterised in that
open edges of the lid (3) and the base (2) are closed by means of Velcro fasteners, zip fasteners or press fasteners that are if necessary metallised.

## Revendications

1. Coffret pour appareils conçu pour être utilisé comme châssis en matière plastique ou support de composants, constitué principalement de polypropylène expansé, pour contenir des composants électriques, électroniques, de mécanique de précision, ainsi que des appareils électriques, électroniques ou des appareils de mécanique de précision. Le coffret pour appareils apparaît sous la forme d'une boîte à montage facile (1) et consiste en un support ou un substrat de matière composite ou en aggloméré laminé, en carton ondulé ou en carton ordinaire, dans lequel le support (10) situé sur le côté intérieur de la boîte présente une surface ou une couche (9) entièrement conductrice et de faible résistance ohmique et est caractérisé en ce que
la coupe plane de la boîte à montage facile (1) possède toutes les perforations nécessaires (12-15) compatibles avec le châssis ou le support de composants utilisé (17, 18) et consiste en une boîte à montage facile (1) par rabats successifs et contenant une cage de Faraday interne.

2. Coffret pour appareils selon la revendication 1, caractérisé en ce que
la boîte à montage facile (1) se compose d'une partie inférieure ou fond (2) et d'un couvercle ou partie supérieure (3), reliés l'un à l'autre par une arête et se rabattant l'un sur l'autre et
en ce que la couche (9) conductrice des parois latérales (4) et frontales (6) du fond (2) consiste en une bande enveloppante (7) servant à mettre en contact la surface conductrice du couvercle (3) et celle du fond (2) lorsque la boîte est repliée.

3. Appareil muni d'un coffret sous forme de boîte à montage facile (1) selon l'une quelconque des revendications 1 ou 2 et d'un châssis en matière plastique ou de support de composants, constitué principalement de polypropylène expansé, pour contenir des composants électriques, électroniques, de mécanique de précision, ainsi que des appareils électriques, électroniques ou des appareils de mécanique de précision comme des ordinateurs individuels ou des appareils de laboratoire, caractérisé en ce que
la boîte à montage facile (1) et le châssis ou le support de composants (17, 18) forment une unité mécanique statique et une unité électrique intégrale protégeant contre le rayonnement sortant et entrant.

4. Coffret pour appareils ou appareil selon l'une quelconque des revendications 1 à 3, caractérisé en ce que
les faces extérieures de la boîte à montage facile (1) sont recouvertes partiellement ou entièrement avec du papier décoratif (11).

5. Coffret pour appareils ou appareil selon l'une quelconque des revendications 1 à 4, caractérisé en ce que
la boîte à montage facile (1) constituée de plastique, feuille, tissu, carton, simili-cuir ou cuir et dont l'un des côtés de la coupe sert d'écran ou de surface de contact entre les surfaces internes et un matériau à forte conductibilité superficielle, forme, lorsqu'elle est repliée, une cage de Faraday intérieure.

6. Coffret pour appareils ou appareil selon l'une quelconque des revendications 1 à 5, caractérisé en ce que
la cage de Faraday est construite à partir de tissus, réseaux, filaments, feuilles et couches métalliques ou couches métallifères situés sur les faces intérieures et extérieures réunis pour former la boîte à montage facile (1) par technique de pliage et à partir de bandes enveloppantes (7) servant à mettre en contact les faces intérieures et extérieures et les surfaces métalliques.

7. Appareil selon l'une quelconque des revendications 3 à 6, caractérisé en ce que
les deux parois latérales (4) de la boîte à montage facile (1) sont repliées trois fois, la paroi arrière (5) deux fois et la paroi frontale (6) une fois lorsque la boîte a sa forme finale.

8. Appareil selon l'une quelconque des revendications 3 à 6, caractérisé en ce que
les parois latérales intérieures (4') du couvercle (3) se composent de deux parties pliables.

9. Appareil selon l'une quelconque des revendications 3 à 8, caractérisé en ce que
les perforations (12 - 15) servant à l'entrée et à la sortie d'air, aux mécanismes de déplacement, au raccordement ou autres sont recouvertes par des matériaux conducteurs contenant des fibres ou des petites particules métalliques.

10. Appareil selon l'une quelconque des revendications 3 à 9, caractérisé en ce que
les parois latérales (4) et les parois arrière (5) sont maintenues par leurs rebords et dont l'ouverture et la fermeture s'effectuent grâce à des rabats.

11. Appareil selon l'une quelconque des revendications 3 à 10, caractérisé en ce que
une paroi du couvercle (3) forme la paroi arrière (5) et la paroi opposée forme la paroi frontale (6) de l'appareil ou de la boîte à monter (1) et en ce que
le couvercle (3) peut être relevé et rabattu ou replié sur le fond (2).

12. Appareil selon l'une quelconque des revendications 3 à 11, caractérisé en ce que,
pour les composants, la paroi arrière (5) de la boîte, à l'aide d'une barrette de raccordement ou de composants de grande puissance (20) mis à la terre, est verrouillée et mise en contact avec le châssis (17, 18) ou une carte imprimée (16) mise à la terre via au minimum un contact mis à la terre (21) encliquetable ou verrouillable ou une vis de mise à la terre (22).

13. Appareil selon l'une quelconque des revendications 3 à 12, caractérisé en ce que
la surface ou la couche (9) conductrice et de faible résistance ohmique du support (10) déborde des arêtes sur la surface opposée au minimum sur les arêtes libres supérieures des parois latérales (4) et des parois arrière (5) et forme une bande striée enveloppante (7).

14. Appareil selon l'une quelconque des revendications 3 à 13, caractérisé en ce que
au minimum les enveloppes (7) des parois latérales (4) du couvercle (3) et du fond (2) sont positionnées les unes à côté des autres, serrées et mises en contact en respectant un jeu.

15. Appareil selon l'une quelconque des revendications 3 à 14, caractérisé en ce que
au minimum les parois latérales (4) et la paroi arrière (5) du fond (2) sont orientables ou rabattables.

16. Appareil selon l'une quelconque des revendications 3 ou 15, caractérisé en ce que
les arêtes libres de l'appareil situées sur le couvercle (3) et le fond (2) sont verrouillées entre elles par des fermetures autoagrippantes, des fermetures à glissière ou des pressions ou, le cas échéant, en ce qu'elles sont métallisées.
